## Europäisches Patentamt
## European Patent Office
## Office européen des brevets

(11) Veröffentlichungsnummer: **0 246 442**
**A2**

(12) # EUROPÄISCHE PATENTANMELDUNG

(21) Anmeldenummer: 87105300.5

(22) Anmeldetag: 10.04.87

(51) Int. Cl.³: **H 05 K 13/00**
**B 65 G 49/00**

(30) Priorität: 23.05.86 DE 3617346

(43) Veröffentlichungstag der Anmeldung:
25.11.87 Patentblatt 87/48

(84) Benannte Vertragsstaaten:
CH DE FR GB IT LI SE

(71) Anmelder: Scheler, Holger, Dipl.-Ing.
Heidbergredder 30
D-2300 Klausdorf/Schwentine(DE)

(72) Erfinder: Scheler, Holger, Dipl.-Ing.
Heidbergredder 30
D-2300 Klausdorf/Schwentine(DE)

(74) Vertreter: Hansmann, Dierk, Dipl.-Ing.
Jessenstrasse 4
D-2000 Hamburg 50(DE)

(54) Transportrahmen und Vorrichtung zur Verstellung der Kufenelemente.

(57) Es ist vorgesehen, daß der transportrahmen über Doppelgurtfördersysteme sowohl in Quer- als auch in Längsrichtung transportierbar ist und die Kufenelemente in einer Ebene angeordnet sind. Um in Bearbeitungsmaschinen, wie Lötmaschinen, keine Benetzung der Kufenelemente durchzuführen, ist vorgesehen, daß mindestens die Kufenelemente für den Quertransport über Führungselemente verschwenkbar angeordnet sind und innerhalb der Bearbeitungsmaschine oberhalb der Ebene der Gurtförderer liegen.

EP 0 246 442 A2

0246442

## Transportrahmen und Vorrichtung
## zur Verstellung der Kufenelemente

Die Erfindung bezieht sich auf einen Transportrahmen für die Aufnahme von bestückten Flachbaugruppen für die Herstellung elektrischer Leiterplatten zum Transport über Doppelgurtfördersysteme mit Längs- und Quertransportstrecken und Zuführung für Bearbeitungsmaschinen, wie Lötmaschinen und dergleichen, wobei die Aufnahme auf dem Gurtförderer über zugeordnete Kufenelemente des Transportrahmens erfolgt, und eine Vorrichtung zur Verstellung der Kufenelemente.

Es hat sich in der Praxis gezeigt, daß bei der Verwendung von Transportrahmen dieser Art in Verbindung mit üblichen Längs- und Quertransporten über Doppelgurte für den automatischen Materialfluß beim Durchlaufen von Lötmaschinen, insbesondere automatische Wellenlötmaschinen, das Problem der Löt- und Flußmittelbenetzung an den Kufenelementen für den Quertransport auftritt.

Durch diese Benetzungen werden auf den Gleitflächen der Kufenelemente festhaftende Flußmittel und Lötzinnschichten aufgetragen. Mit diesen Schichten ist ein kraftschlüssiger ordnungsgemäßer Reibtransport über Doppelgurtfördersysteme im Dauerbetrieb nicht mehr möglich. Hierbei ist auch zu berücksichtigen, daß handelsübliche Doppelgurtfördersysteme für den Längs- und den Quertransport als Transporthilfsmittel einen Rahmen mit umlaufenden Kufenelementen in einer Ebene benötigen.

In Verbindung mit dem automatischen Flußmittelauftrag durch eine Schäum- oder Sprüheinrichtung sowie dem automatischen Wellenlöten tauchen somit die quer zur

Transporteinrichtung angeordneten Kufenelemente des Transportrahmens in die Medien der Bearbeitungseinrichtungen ein.

Es ist zwar bekannt geworden, Transportrahmen derart auszubilden, daß die Kufenelemente für den Quertransport über dem Niveau der Kufenelemente für den Längstransport angeordnet sind. Beim Einsatz von Transportrahmen mit dieser Ausbildung ist aber die Verwendung handelsüblicher Quertransportsysteme nicht möglich.

Die Aufgabe der Erfindung ist es, einen funktionsfähigen Transportrahmen für den Einsatz handelsüblicher Quertransportsysteme und eine Vorrichtung zur Handhabung zu schaffen, die auf einfache Weise die Benetzung der Kufenelemente verhindert und gewährleistet, daß die Kufenelemente für den Quertransport in einer Ebene mit den Kufenelementen für den Längstransport liegen.

Die Lösung dieser Aufgabe erfolgt erfindungsgemäß dadurch, daß mindestens die Kufenelemente für den Quertransport über Führungselemente verschwenkbar oder verschiebbar am Aufnahmerahmen angeordnet sind und während des Transportweges innerhalb von Bearbeitungsmaschinen in einen Bereich oberhalb der Ebene der Gurtförderer verstellbar sind.

Hierdurch ist es möglich, im Bereich der Bearbeitungsmaschinen die Kufenelemente der Transportrahmen aus dem Gefahrenbereich der Benetzung oder dergleichen herauszuschwenken bzw. zu verschieben und nach dem Durchlauf eine Rückstellung durchzuführen, so daß ein Quertransport auch nach einem Lötprozeß einwandfrei ermöglicht wird.

Um eine einfache Anordnung zu ermöglichen, wird vorgeschlagen, daß die Kufenelemente für den Quertransport über Zapfen als Führungselemente in seinen Endbereichen am Rahmen derart schwenkbar gelagert sind, daß jedes Kufenelement in der verschwenkten Lage den Bereich der Tragebene freigibt.

Zur besseren Einstellung und Fixierung der entsprechenden Positionen wird vorgeschlagen, daß die verschwenkbaren Kufenelemente für den Quertransport über korrespondierende Rastelemente am Rahmen und an den Kufenelementen in ihren Endstellungen festsetzbar sind. Eine einfache Ausbildung hierfür besteht darin, daß die Rastelemente durch federbelastete Kugeln und zugeordnete Aufnahmen gebildet sind.

Zur Verstellung der Kufenelemente in mechanischer Weise wird vorgeschlagen, daß in Transportrichtung vor der Bearbeitungsmaschine beiderseits den Endbereichen des Aufnahmerahmens nach außen schwenkbare Betätigungsarme den Kufenelementen zum Verschwenken aus der Tragebene zugeordnet sind. Ferner ist zur Rückstellung vorgesehen, daß in Trnsportrichtung nach der Bearbeitungsmaschine beiderseits den Endbereichen des Aufnahmerahmens absenkbare Nocken den Kufenelementen zum Verschwenken in die Tragebene zugeordnet sind.

In der Zeichnung sind ein Transportrahmen und zugehörige Betätigungsvorrichtungen schematisch dargestellt. Es zeigen:

Fig. 1 eine Anordnung einer Lötstraße,

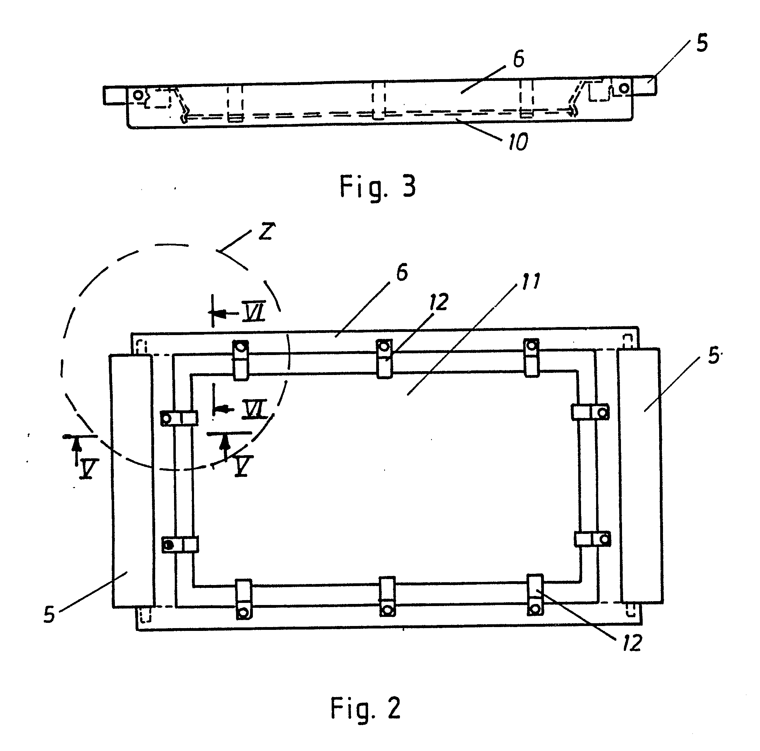

Fig. 2   eine Draufsicht auf einen Lötrahmen,

Fig. 3   eine Seitenansicht gemäß Fig. 2

Fig. 4   eine Einzelheit Z gemäß Fig. 2 im
         vergrößerten Maßstab mit verschwenkten
         Kufenelementen,

Fig. 5   einen Schnitt gemäß Linie V-V der
         Fig. 4,

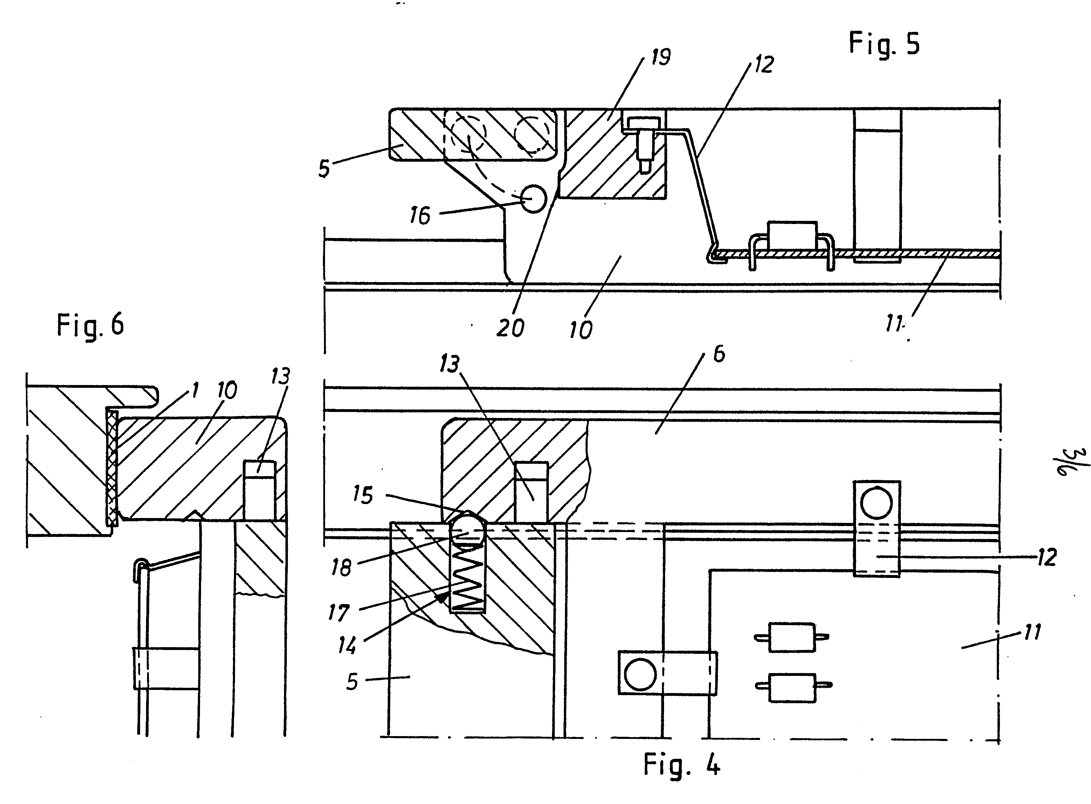

Fig. 6   einen Schnitt gemäß Linie VI-VI der
         der Fig. 4,

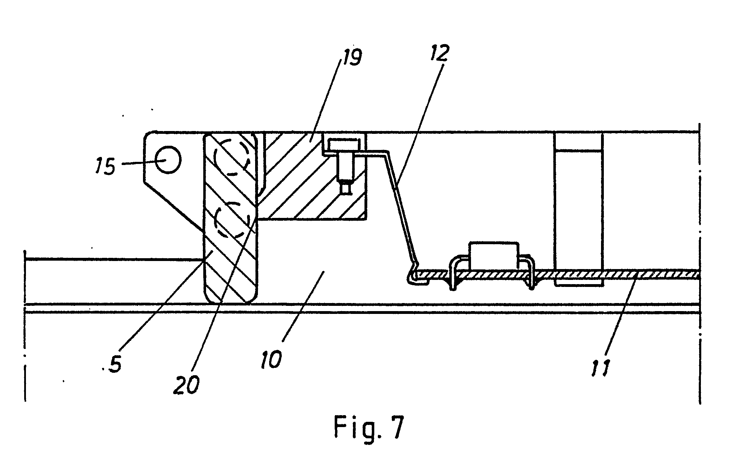

Fig. 7   einen Schnitt entsprechend Fig. 5
         mit dem Kufenelement in der Tragposition

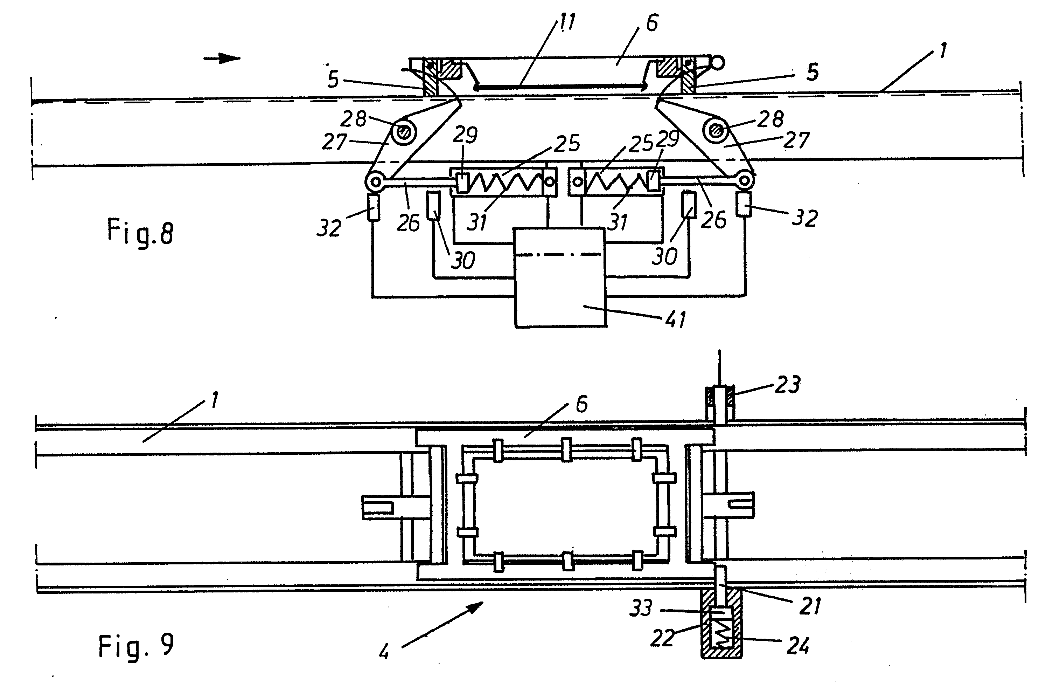

Fig. 8   eine Seitenansicht einer Schwenkvorrichtung für die Kufenelemente aus der
         Trageposition,

Fig. 9   eine Draufsicht gemäß Fig. 8,

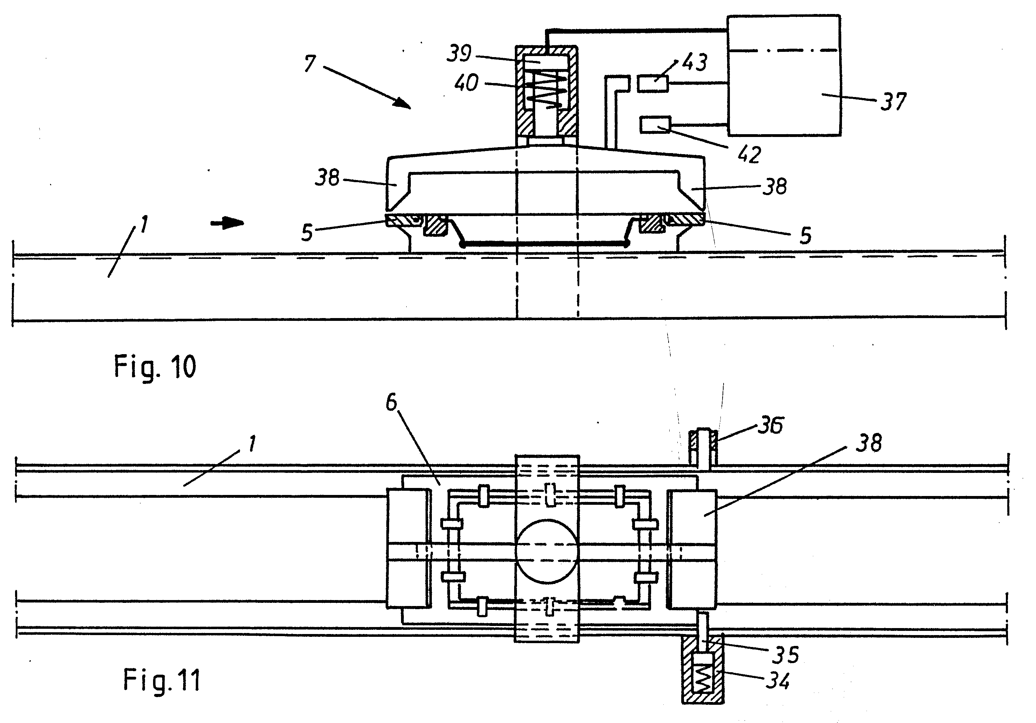

Fig.10   eine Seitenansicht einer Schwenkvorrichtung für die Kufenelemente in die
         Trageposition,

Fig.11   eine Draufsicht gemäß Fig. 10.

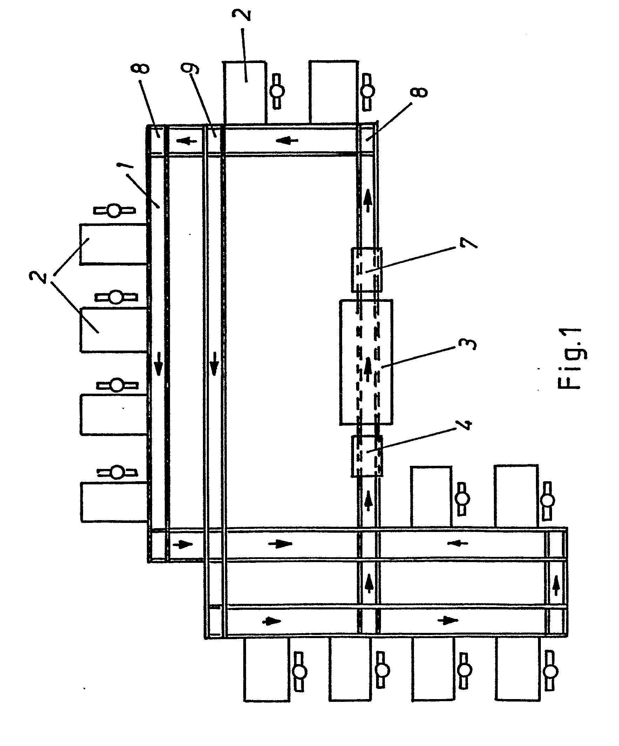

Die dargestellte Lötstraße mit einem Doppelgurttransportsystem 1 gemäß Fig. 1, besitzt zugeordnete Arbeitsplätze
2 und führt über eine schematisch angedeutete Wellenlötanlage 3 mit einer vorgeschalteten in Schwenkrichtung 4 für Kufenelemente 5 von nicht näher dargestellten Transportrahmen 6 aus der Tragposition und einer entsprechend nachgeschalteten Schwenkrichtung 7 für die Kufenelemente 5 in die Tragposition. In den Knoten- bzw. Eckpunkten des Doppelgurttransportsystems 1 sind Umsetzeinrichtungen 8 und Hub- Quereinheiten 9 eingesetzt.

Der Transportrahmen 6 wird aus dem eigentlichen Rahmenteil gebildet, der in diesem Fall feststehende Längskufen 10 aufweist und an seinen Querseiten um 90° verschwenkbare Kufenelemente 5 aufweist, die als Träger dem Doppelgutförderer 1 zugeordnet sind. Eine zu lötende Flachbaugruppe 11 wird über Halteklammern 12 kraftschlüssig am Transportrahmen 6 gehalten.

Die verschwenkbaren Kufenelemente 5 sind über Zapfen 13 am feststehenden Rahmenteil des Transportrahmens 6 oberhalb der aufgenommenen Flachbaugruppe 11 gelagert und in diesem Fall über korrespondierende Rastelemente 14,15 bzw. 16 in beiden Endstellungen festsetzbar. Hierbei wird ein Rastelement 14 durch eine Druckfeder 17 und eine Kugel 18 gebildet, wobei das zugeordnete Rastelement jeweils durch eine Aufnahme 15 und 16 in der unterschiedlichen Endstellung des verschwenkbaren Kufenelementes 5 gebildet ist.

Die Längskufen 10 werden dabei durch zwei Querstege 19 auf Abstand gehalten, die auch gegebenenfalls mit entsprechender Anschlagfläche 20 den Drehwinkel der Kufenelemente 5 begrenzen.

Beim Transport des Transportrahmens 6 durch die Wellenlötmaschine 3 werden die Längskufen 10 durch die Lage oberhalb der Flachbaugruppe 11 auf ihrer Unterseite nicht vom Flußmittel bzw. Lötzinn benetzt. Die verschwenkbaren Kufenelemente 5 als Querkufen befinden sind in der verschwenkten Position und werden deshalb ebenfalls nicht benetzt.

Das Verschwenken der Kufenelemente 5 vor und nach der Wellenlötmaschine 3 ist selbstverständlich individuell von Hand möglich. In diesem Ausführungsbeispiel sind entsprechende mechanische Schwenkeinrichtungen 4 und 7 für das Verschwenken der Kufenelemente 5 angeordnet.

Die vor der Wellenlötmaschine 3 angeordnete Schwenkeinrichtung 4 gemäß Fig. 8 und 9 funktioniert derart, daß durch das Doppelgurttransportsystem der Transportrahmen 6 in Pfeilrichtung bewegt wird und dabei gegen eine Kolbenstange 21 eines druckmittelbetätigten Anschlages 22 läuft und einen Sensor 23 aktiviert. Im drucklosen Zustand wird die Kolbenstange 21 durch eine Rückstellfeder 24 in einer Anschlagposition gehalten.

Durch den aktivierten Sensor 23 werden über eine Steuerung 41 beide einfach wirkenden Zylinder 25 betätigt und über deren Kolbenstangen 26 Schwenkhebel 27 um ihre Achsen 28 um ca. 90° geschwenkt. Dabei werden die Kufenelemente 5 aus der senkrechten Stellung in die waagerechte Stellung geschwenkt und durch die Rastelemente 14, 15 in dieser Lage gehalten.

Durch Einwirken eines Druckmediums erreichen die Kolben 29 der Zylinder 25 Ihre Endstellung und aktivieren dabei Sensoren 30, welche über die Steuerung 41 das Einwirken des Druckmediums aufheben.

Durch zugeordnete Rückstellfedern 31 werden die Kolben 29 und damit die Schwenkhebel 27 in ihre Ausgangslage zurück bewegt und zugeordnete Sensoren 32 aktiviert, die über die Steuerung Druckmedium auf einen Kolben 33 des Anschlages 22 steuern, wobei die Kolbenstange 21 gegen die Rückstellfeder 24 bewegt wird und damit die Blockade des Transportrahmens 6 freigibt.

Nach dem Passieren des Transportrahmens 6, wird die Kolbenstange 21 durch die Nichtaktivierung des Sensors 23 in ihre Blockierstellung gebracht, wobei über die Steuerung die Einwirkung des Druckmediums beendet und die Kolbenstange 21 durch die Rückstellfeder 24 in die Ausgangsstellung bewegt wird.

Der Transportrahmen 6 wird mit verschwenkten Kufenelementen 5 durch die Wellenlötmaschine 3 transportiert und gelangt nach Prozeßablauf in die Schwenkeinrichtung 7.

Die Schwenkeinrichtung 7 enthält einen steuerbaren Anschlag 34, der den Verlauf des Transportrahmens 6 durch eine Kolbenstange 35 begrenzt. Ein zugeordneter Sensor 36 meldet das Vorhandensein eines Transportrahmens 6 und löst über eine Steuerung 37 eine Schließbewegung von absenkbaren Nocken 38 aus. Die Nocken 38 werden dabei über einen Kolben 39 gegen den Druck einer Rückstellfeder 40 betätigt und verschwenken die Kufenelemente 5 in die Tragebene. Bei Erreichen seiner unteren Endlage wird ein Sensor 42 aktiviert, der über die Steuerung 37 den Kolben 39 entlastet und diesen über die Rückstellfeder 40 wieder in die obere Endlage bringt.

In dieser Lage wird ein Sensor 43 betätigt, welcher durch die Steuerung 37 den Anschlag 34 außer Eingriff mit dem Transportrahmen 6 bringt. Nach Passieren des Transportrahmens 6 wird der Anschlag 34 durch die Nichtaktivierung des Sensors 36 wieder in seine Blockierstellung gebracht. Die Schwenkeinrichtung 7 ist nun aktiviert für einen nachfolgenden Transportrahmen 6.

Der Transportrahmen 6 kann nach dem Verschwencken der Kufenelemente 5 innerhalb des Transportsystemes über Umsetzeinrichtungen 8 und über Hubquereinheiten 9 auf Quertransportstrecken transportiert werden, da die Aufnahmeflächen der Kufenelemente 5 in einer Ebene mit denen der Längskufen 10 liegen.

## Patentansprüche

1. Transportrahmen für die Aufnahme von bestückten Flachbaugruppen für die Herstellung elektrischer Leiterplatten zum Transport über Doppelgurtfördersysteme mit Längs- und Quertransportstrecken und Zuführung für Bearbeitungsmaschinen, wie Lötmaschinen und dergleichen, wobei die Aufnahme auf dem Gurtförderer über zugeordnete Kufenelemente des Transportrahmens erfolgt, dadurch gekennzeichnet, daß mindestens die Kufenelemente (5) für den Quertransport über Führungselemente (13) verschwenkbar oder verschiebbar am Aufnahmerahmen angeordnet sind und während des Transportweges innerhalb von Bearbeitungsmaschinen (3) in einen Bereich oberhalb der Ebene der Gurtförderer (1) verstellbar sind.

2. Transportrahmen nach Anspruch 1, dadurch gekennzeichnet, daß die Kufenelemente (5) für den Quertransport über Zapfen (13) als Führungselemente in seinen Endbereichen am Rahmen derart schwenkbar gelagert sind, daß jedes Kufenelement (5) in der verschwenkten Lage den Bereich der Tragebene freigibt.

3. Transportrahmen nach Anspruch 1 oder 2, dadurch gekennzeichnet, daß die verschwenkbaren Kufenelemente (5) für den Quertransport über korrespondierende Rastelemente (14,15,16) am Rahmen und an den Kufenelementen (5) in ihren Endstellungen festsetzbar sind.

4. Transportrahmen nach Anspruch 3, dadurch gekennzeichnet, daß die Rastelemente (14) durch federbelastete Kugeln (18) und zugeordnete Aufnahmen (15,16) gebildet sind.

5. Vorrichtung zur Verstellung der Kufenelemente am Transportrahmen nach Anspruch 1, dadurch gekennzeichnet, daß in Transportrichtung vor der Bearbeitungsmaschine (3) beiderseits den Endbereichen des Aufnahmerahmens (6) nach außen schwenkbare Betätigungsarme (27) den Kufenelementen (5) zum Verschwenken aus der Tragebene zugeordnet sind.

6. Vorrichtung zur Verstellung der Kufenelemente am Transportrahmen nach Anspruch 1, dadurch gekennzeichnet, daß in Transportrichtung nach der Bearbeitungsmaschine (3) beiderseits den Endbereichen des Aufnahmerahmens (6) absenkbare Nocken (38) den Kufenelementen (5) zum Verschwenken in die Tragebene zugeordnet sind.

Fig.1

Fig. 3

Fig. 2

Fig. 5

Fig. 4

Fig. 6

Fig. 7

Fig.8

Fig. 9

0246442

Fig. 10

Fig. 11

0246442